(19) Europäisches Patentamt
European Patent Office
Office européen des brevets

(11) **EP 2 309 515 A1**

(12) **EUROPEAN PATENT APPLICATION**

(43) Date of publication:
**13.04.2011 Bulletin 2011/15**

(51) Int Cl.:
**G11C 11/54** (2006.01)　　**G11C 11/56** (2006.01)
**G11C 27/00** (2006.01)　　**G11C 13/02** (2006.01)

(21) Application number: **09172679.4**

(22) Date of filing: **09.10.2009**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(71) Applicant: **Commissariat à l'Énergie Atomique
et aux Énergies Alternatives
75015 Paris (FR)**

(72) Inventors:
• **Zhao, Weisheng
91300, Massy (FR)**
• **Agnus, Guillaume
78210, Saint-Cyr-L'Ecole (FR)**

• **Bourgoin, Jean-Philippe
78960, Voisins-Le-Bretonneux (FR)**
• **Derycke, Vincent
78180, Montigny-Le.Bretonneux (FR)**
• **Gamrat, Christian
91940, Les Ulis (FR)**

(74) Representative: **Lucas, Laurent Jacques et al
Marks & Clerk France
Conseils en Propriété Industrielle
Immeuble " Visium "
22, avenue Aristide Briand
94117 Arcueil Cedex (FR)**

(54) **Memory device comprising an array of nanoscale cells**

(57)　　The invention relates to a memory device (1) comprising an array of non-volatile memory cells (2). It also relates to a non-volatile memory chip comprising an array of such memory devices and capable to store both the digital and analogue values in such a memory device. The programming and reading methods and fabrication process are also presented.

According to the invention, each memory cell (2) is embodied by a nanoscale component having three terminals, an electrical characteristic between a first and a second terminal of each nanoscale component (2) being able to represent a data and being able to be modified by applying a signal to this first terminal or to this second terminal, a third terminal of each nanoscale component being able to prevent the electrical characteristic of the corresponding nanoscale component from being modified and sensed by applying a positive and non-null voltage to it.

FIG.1

## Description

The invention relates to a memory device comprising an array of non-volatile nanoscale memory cells. It also relates to a non-volatile memory chip comprising an array of such memory devices and capable to store both digital and analogue values in such a memory device. The invention finally relates to the storage of a discrete signal.

For at least thirty years, CMOS (Complementary Metal-Oxide Semiconductor) technology has been the dominant technology for producing memory chips. This is mainly due to its increasing performances in terms of area, power and speed, as described by Moore's law. For example, flash memory is a key technology for the development of low power mobile applications. However, the future miniaturisation of CMOS-based memory blocks is limited down to nodes of 22-nanometres (nm) because of physical barriers such as quantum effects. Indeed, below this size, the Boolean computing can no more be applied due to high leakage currents. As a consequence, the difference between the "0-state" and the "1-state" shrinks. Moreover, for CMOS nodes of 90 nm or smaller, the leakage currents involve issues of static power performances. This greatly limits the standby time of embedded devices and the complexity of their applications. In this context, nanometre scale components, also called "nanoscale components" or "nanocomponents", are considered of great interest for improving even further the memory block density and the power performances beyond Moore's law.

Among the nanocomponents, carbon nanotube devices, nanowire devices and memristors have been recently proposed to address memory applications. They promise high density since the memory cells can be fabricated in nanometre scale and can perform multistable states due to a high ratio between the 0-state and the 1-state. Moreover, most of the nanocomponent-based memory elements are non-volatile. This allows them to be used advantageously for low power applications, in particular for mobile equipments. Another advantage of nanocomponents is their ability to be easily interfaced with CMOS circuits, which remain irreplaceable for controlling the array of memory cells. Thus, a good strategy would be to achieve a hybrid nano/CMOS circuit in which nanocomponents play the role of memory cells and the CMOS circuit controls the writing and the reading of the memory cells. Implementing a set of nanocomponents, called a nano building block or a nano-computing core, above a CMOS circuit is considered as one of the most promising fabrication methods. However, to date, most research efforts in this field are concentrated on the device level and only a few proposals relate to global architectures for hybrid nano/CMOS memory circuits. One proposal consists in a three-dimensional (3-D) cross-bar structure with memristors. Although such a nano building block promises higher storage density than conventional CMOS memory circuits, it requires complex CMOS circuits for the selection of the memory cells. In particular, at least one MOS transistor per memory cell is required for individual selection of the memory cells. This greatly limits the storage density and the access speed. Furthermore, the 3-D cross-bar structure requires at least two additional metal layers and a number of masks after the CMOS process for manufacturing it. This increases the fabrication cost, reduces the reliability of the structure and limits its practical applications. Other nanocomponents, such as phase-change, resistive and magnetoresistive RAM, can be used as memory cells in a hybrid nano/CMOS memory circuit, but they all need at least one MOS transistor per memory cell and two additional metal layers after the CMOS process.

The present invention aims at providing a non-volatile memory chip which overcomes at least some of the drawbacks described above. The invention so proposes a non-volatile memory device comprising an array of non-volatile memory cells. According to the invention, each memory cell is embodied by a nanoscale component having at least three terminals, an electrical characteristic between a first and a second terminal of each nanoscale component being able to represent a data and being able to be modified by applying a signal to the first terminal or to the second terminal, a third terminal of each nanoscale component being able to prevent the electrical characteristic of the corresponding nanoscale component from being modified and sensed by applying a positive and non-null voltage to it.

This memory device can store both binary and analogue values.

In one embodiment, the nanoscale components are field-effect transistors, each field-effect transistor comprising a drain and a source forming the first and second terminals of the corresponding nanoscale component, a resistance between the drain and the source of each field-effect transistor being able to be modified by voltage pulses applied to its drain or to its source, each field-effect transistor further comprising a gate forming the third terminal of the corresponding nanoscale component and preventing the resistance between the drain and the source of the corresponding field-effect transistor from being modified and sensed when a positive and non-null gate voltage is applied to it.

According to this embodiment, the field-effect transistors may each comprise a second gate, their resistances between the drains and the sources returning to an initial state by applying a negative and non-null voltage to their second gate.

The field-effect transistors may also be carbon nanotube field-effect transistors. In this case, they can each comprise an optical gate, their resistances between the drains and the sources returning to an initial state by exposing their optical gate to a light beam of a given wavelength. The optical gates of all carbon nanotube field-effect transistors can be shared so as to reset all resistance values to their initial state.

In one embodiment, the array of memory cells comprises M rows by N columns of memory cells enabling the storage of M words of N bits each, the first terminals of the nanoscale components in each column being respectively connected together so as to form bit lines, the second terminals of the nanoscale components in each column being respectively connected together so as to form output lines, and the third terminals of the nanoscale components in each row being respectively connected together so as to form word lines.

The memory device can further comprise a CMOS control circuit comprising a first metal layer and an oxide barrier forming part of the array of memory cells. The memory device so forms a compact hybrid nano/CMOS circuit where the CMOS control circuit drives the writing and the reading of the memory cells.

According to this last embodiment, the array of memory cells may comprise a second metal layer, the first metal layer so embodying the word lines and the second metal layer embodying the bit lines and the output lines.

In addition, the field-effect transistors can each comprise at least a nanotube, at least a nanowire or at least a nanoribbon implemented on a word line between a bit line and an output line of a given column.

The CMOS control circuit may comprise a programming circuit allowing to write data word by word in the array of memory cells, the word lines being successively selected.

In a first way, the programming circuit comprises a pulse generator for each column of the array of memory cells, the pulse generators being able to deliver voltage pulses of given amplitude and duration, an output of each pulse generator being connected to a bit line.

In a second way, the programming circuit comprises a pulse generator and, for each column of the array of memory cells, a current comparator and a commandable switch, each current comparator allowing to compare the data to be stored in a nanoscale component of the corresponding column with the data currently stored in said nanoscale component, each commandable switch connecting the pulse generator to one bit line and being controlled by an output of the corresponding current comparator.

The invention also proposes a non-volatile memory chip comprising an array of memory devices as described above.

The invention eventually proposes the storage of a discrete signal over a period of time, characterised in that the discrete signal is stored in a word of a memory device as described above, the electrical characteristic between the first and second terminals of each nanoscale component associated to said word being representative of an analogue value of a sample.

An advantage of the invention is that it allows high storage density insofar as the memory cells only contain nanocomponents and no MOS transistors, the size of each individual nanocomponent being about a few tens of nanometres. In addition, the memory cell array can be implemented on a CMOS circuit controlling the access to the memory cell array. Thus, the final die area mainly depends on the surface of the CMOS circuit, which can be very small since the access to a memory cell is controlled locally by the nanocomponent itself. The high storage density can also be provided by storing analogue data in a single memory cell.

Other advantages and better understanding of the invention will appear from the following description taken into conjunction with the accompanying drawings, in which:

- figure 1 is an exemplary embodiment of a memory block according to the invention;
- figure 2 schematically illustrates an optically-gated carbon nanotube field-effect transistor;
- figure 3 shows the electrical and optical characteristics of an optically-gated carbon nanotube field-effect transistor;
- figure 4 represents a memory device including a memory block as illustrated in figure 1 and a first exemplary circuit for programming it;
- figure 5 represents a memory device including a memory block as illustrated on figure 1 and a second exemplary circuit for programming it;
- figures 6A-6B show the experimental result of data programming using the circuits shown in figure 5;
- figure 7 illustrates an exemplary multi-function circuit comprising a memory block according to the invention;
- figure 8 illustrates a type of analogue data that can be advantageously stored by a memory block according to the invention;
- figure 9 schematically illustrates, in a top view, a possible implementation of the memory block illustrated on figure 1;
- figure 10 is a schematic cross-section view of the implementation of the memory block illustrated on figure 9;
- figures 11A-11F schematically illustrate an example of fabrication process for the implementation of the memory block illustrated on figures 9 and 10.

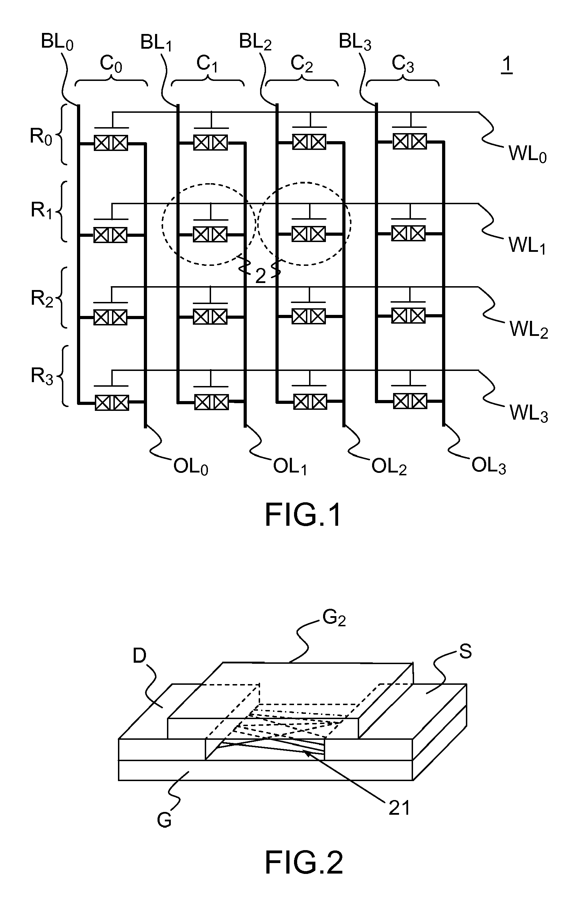

Figure 1 illustrates an exemplary embodiment of a memory block according to the invention. The memory block 1 forms the storage part of the memory device. It comprises an array of memory cells, each memory cell 2 being embodied by a nanocomponent having three terminals. On figure 1, a matrix of four rows $R_0$-$R_3$ by four columns $C_0$-$C_3$ of memory cells is represented. More generally, the memory block 1 can comprise M rows by N columns of memory cells 2, enabling the storage of M words of N bits each. The number of rows and columns in a memory block according to the invention can be very large since the memory cells do not require any components in addition to the three-terminal nanocomponents. As an example, these nanocomponents can be carbon nanotube field-effect transistors, abbreviated as CNTFETs. These nanocomponents can be optically gated. Such transistors, abbreviated as OG-CNTFETs, are for example described in patent US 7,323,730, issued on January 29, 2008.

Figure 2 schematically illustrates an OG-CNTFET. An OG-CNTFET, like a CNTFET, comprises a gate G, a drain D and a source S. A nanotube network 21 is implemented on the gate G, on a channel between the drain D and the source S. The nanotube network 21 could be replaced by a nanowire network or a nanoribbon network. Instead of a network, it could also be a single nanotube, nanowire or nanoribbon. The nanotube network 21 permits an electrical conduction between the two terminals D and S, which can be modified by voltage pulses applied either to the drain D or to the source S. Thus, this electrical conduction or, in other words, the resistance $R_{DS}$ between the drain D and the source S of an OG-CNTFET can be representative of a data, which can be a digital or an analogue value. In addition to the three physical terminals of a conventional transistor, an OG-CNTFET comprises a second "gate" sensitive to light of a given wavelength and allowing the resistance $R_{DS}$ of the transistor to be modified. This gate is so called an optical gate $G_2$. For example, the optical gate $G_2$ can be implemented on the top of a CNTFET. It can be a polymer material, for example poly (3-Octylthiophene), abbreviated as P3OT, or more generally any material responding to light by creating an electric field, able to influence the transport properties of the nanotube, nanowire or nanoribbon network. In memory applications for example, this gate $G_2$ can be shared globally for a number of OG-CNTFETs. In other embodiments of the invention, the second gate is made of a conductive material separated from the nanotube, nanowire or nanoribbon network (possibly a single nanotube, nanowire or nanoribbon) by an appropriate insulator. With such embodiments, the resistance $R_{DS}$ is initialized by an electrical voltage.

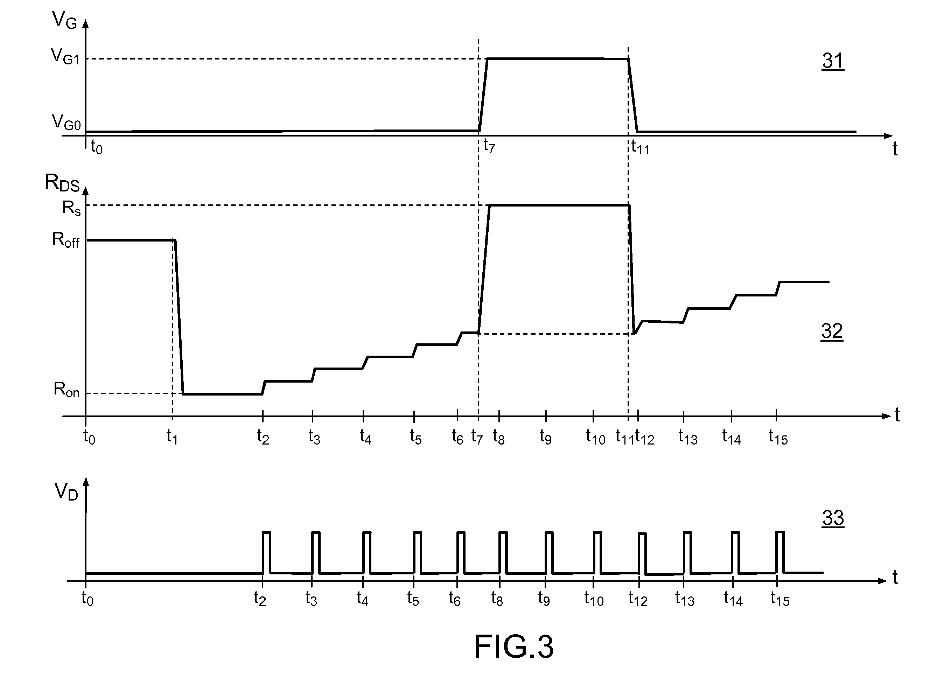

Figure 3 shows the electrical and optical characteristics of an OG-CNTFET. Three graphs are plotted against time t. A first graph 31 represents the gate voltage $V_G$ applied to the gate G of an OG-CNTFET; a second graph 32 represents the resistance value $R_{DS}$ between the drain D and the source S of the OG-CNTFET and a third graph 33 represents the drain voltage $V_D$ applied to the drain D of the OG-CNTFET. The resistance value $R_{DS}$ can vary between a maximum magnitude, referred to as $R_{off}$, and a minimum magnitude, referred to as $R_{on}$. At the origin to of the graphs, the resistance value $R_{DS}$ is considered as being $R_{off}$, the gate voltage $V_G$ is considered as being $V_{G0}$, which is approximately the ground potential, and the drain voltage $V_D$ is approximately null, that is to say at the ground potential. At an instant $t_1$, the optical gate $G_2$ of the transistor is exposed to a light beam at a wavelength it is sensible. As a consequence, electrons are trapped at the nanotube/gate dielectric interface, thus increasing the density of charges within the nanotubes of the network 21. This improves the electrical conduction between the drain D and the source S, lowering the resistance value $R_{DS}$ down to $R_{on}$. At an instant $t_2$, a first voltage pulse is applied to the drain D. This evacuates a part of the trapped electrons, which leads to an increase of the resistance value $R_{DS}$. The amplitude of the resistance increase depends on the amplitude and the duration of the voltage pulse: the resistance value $R_{DS}$ is thus fully tuneable between $R_{on}$ and $R_{off}$. For example, as illustrated on figure 3, it can be slightly increased upon application of voltage pulses to the drain D. At instants $t_3$, $t_4$, $t_5$ and $t_6$, voltage pulses are applied to the drain D of the transistor. Each voltage pulse implies an increase of the resistance value $R_{DS}$. The resistance value $R_{DS}$ can so be adjusted step by step to roughly any value comprised between $R_{off}$ and $R_{on}$. At an instant $t_7$, the gate voltage $V_G$ is led to a voltage of about the same amplitude and of the same sign as that of the voltage pulses, called $V_{G1}$. It results in a reversible increase of the resistance $R_{DS}$ to a value $R_S$. This value $R_S$ can be much higher than $R_{off}$, and so reduces the current that can pass between the drain D and the source S of the OG-CNTFET down to nearly zero. For all the time the voltage $V_{G1}$ is applied to the gate, the resistance $R_{DS}$ cannot be changed by voltage pulses applied to the drain D or to the source S of the transistor, as it is the case at instants $t_8$, $t_9$ and $t_{10}$. When the gate voltage $V_G$ returns to approximately zero at instant $t_{11}$, the resistance $R_{DS}$ recovers the value it had just before the raise of the gate voltage at instant $t_7$. Thus, the presence of a voltage of about the same amplitude as that of the voltage pulses shields the OG-CNTFET from the effect of the voltage pulses. At instants $t_{12}$, $t_{13}$, $t_{14}$ and $t_{15}$, voltage pulses are applied to the drain D of the transistor. As the gate voltage $V_G$ is at $V_{G0}$, the resistance value $R_{DS}$ slightly increases at each voltage pulse. The resistance value $R_{DS}$ can so be increased up to attain $R_{off}$.

On figure 1, the memory block 1 comprises an array of four rows $R_0$-$R_3$ by four columns $C_0$-$C_3$ of OG-CNTFETs. It is to be understood that any type of three or four-terminal nanocomponents with a variable electrical characteristic between two of their terminals and with a third terminal able to prevent the electrical characteristic from being modified or sensed can be used instead of the OG-CNTFETs. In case the memory cells 2 are embodied by other nanoscale FET transistors, the resistance value $R_{DS}$ can for example return to $R_{on}$ by applying a negative voltage at the third terminal G. In the example of figure 1, the drains D of the OG-CNTFETs in each column are respectively connected together so as to form bit lines $BL_0$-$BL_3$; their sources S in each column are respectively connected together so as to form output lines $OL_0$-$OL_3$ and their gates G in each row are respectively connected together so as to form word lines $WL_0$-$WL_3$. Alternatively, the drains D can form the output lines and the sources S the bit lines. The bit lines, the output lines and the word lines are globally referred to as BL, OL and WL, respectively. All the OG-CNTFETs in the memory block 1 can share the same optical gate $G_2$. Several memory blocks can be assembled in order to form a memory chip. In this case, all the optical gates $G_2$ of the memory chip can be shared. The resistances $R_{DS}$ of all the OG-CNTFETs of the memory block or of the memory chip can so be reset at the same time from any state to the minimum resistance amplitude $R_{on}$ by a light beam.

The programming of a memory block according to the invention, that is to say the writing of data in its memory cells, starts with a reset of the resistances $R_{DS}$ of all OG-CNTFETs of this memory block. Then, voltage pulses are sent to the drains D via bit lines BL, while the word lines WL select the row, i.e. the word, to be written. In particular, the different words of the memory block can be written sequentially by selecting successively the corresponding rows. In a standby state, that is to say when a word must not be written nor read, the voltage $V_{G1}$ is applied to all gates G of the OG-CNTFETs belonging to the corresponding row via its word line WL. Thus, the resistances $R_{DS}$ of these OG-CNTFETs cannot be modified. The power consumption of the OG-CNTFETs in a standby state is very limited since their resistance $R_{DS}$ is relatively high, the current $I_{DS}$ passing from the drain to the source being nearly zero. When a row is selected for writing, the voltage $V_{G0}$ is applied to the corresponding word line WL. This voltage $V_{G0}$ is about zero volt. In the meantime, voltage pulses can be applied to the bit lines BL in the columns where the data need to be changed. For each column, there can be a single voltage pulse or several voltage pulses according to the amplitude and the duration of the voltage pulses, and according to the resistance $R_{DS}$ required for the OG-CNTFET of this column. Obviously, several voltage pulses can be applied to the drain of an OG-CNTFET either consecutively, the corresponding word line WL remaining selected for all the time the data is written in the OG-CNTFET, or periodically, the rows being successively selected several times each and a single voltage pulse being applied to the drain of the OG-CNTFET for each row selection. The memory block according to the invention allows parallel writing, i.e. the writing of several words at the same time. These words are written with the same contents and this method can accelerate the programming of a large array. To that end, the corresponding rows are selected simultaneously by applying a voltage $V_{G0}$ to all the corresponding word lines WL.

The reading of a memory block according to the invention is similar to the programming. Instead of applying voltage pulses to the bit lines BL, a relatively low voltage $V_{Dr}$ is applied to the bit lines BL, allowing the data stored in the memory cells 2 of the selected row to be read. This voltage $V_{Dr}$ should be low enough so as not to change the state of the OG-CNTFET. It is for example comprised between 0.1 V and 0.4 V. When a row is selected for reading, the voltage $V_{G0}$ is applied to the corresponding word line WL, all other word lines being kept at the voltage $V_{G1}$. The voltage of the output lines OL can be set at a lower voltage than that of the bit lines BL, for example at the ground potential, and thus a current

$I_{DS}$ representative of the resistance $R_{DS}$ of the OG-CNTFET of the selected row can be sensed on each output line OL. Similarly as for writing, the resistance $R_{DS}$ of the OG-CNTFETs that are not selected is relatively high. As a result, nearly no current passes through these OG-CNTFETs, the currents on the output lines OL being almost equal to the currents passing through the OG-CNTFETs of the selected rows. In other words, there are little noise currents during the reading of a memory block. It permits to build very large memory blocks of any size with low power consumption, for example comprising 128 words of 128 bits.

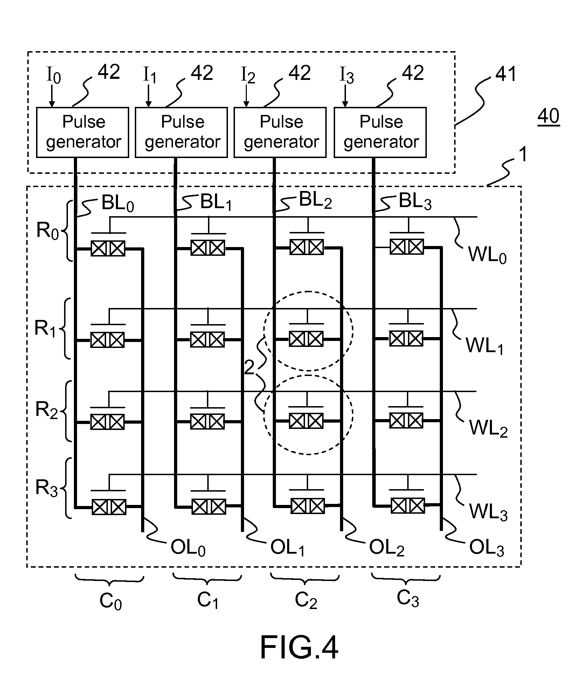

Figure 4 represents a memory device 40 including a memory block 1 according to the invention and a first exemplary circuit 41 for programming the memory block 1. This circuit 41 comprises a pulse generator 42 for each column $C_0$-$C_3$ of the memory block 1, an output of each pulse generator 42 being connected to a bit line $BL_0$-$BL_3$. The pulse generators 42 can be carried out in CMOS technology. Advantageously, the programming circuit 41 and the memory block 1 are assembled so as to form a hybrid nano/CMOS memory device. The programming circuit 41 forms a first block and the memory block 1 forms a nano building block implemented on top of the programming circuit 41. As previously mentioned, when a word is to be written in a row $R_0$-$R_3$, the respective word line $WL_0$-$WL_3$ is activated by applying the voltage $V_{G0}$ to it, the other rows $R_0$-$R_3$ being kept in a standby state with the voltage $V_{G1}$. Each pulse generator 42 receives the data to be written $I_0$-$I_3$ and determines the duration and the number of voltage pulses to apply to the bit line $BL_0$-$BL_3$. This example of memory device 40 can be used to store either binary data or analogue data. To store binary data, only a single long voltage pulse is required. To store analogue data, a number $N_{pulse}$ of voltage pulses must be applied. This number of pulses is a fraction of the total number $N_{max}$ of pulses required so that the resistance $R_{DS}$ reaches the resistance value $R_{off}$ starting from $R_{on}$. The number $N_{max}$ can be defined by the following formula:

$$N_{max} = N_{level} - 1,$$

where $N_{level}$ is the number of quantification levels wanted for the analogue data. In case a higher precision is required, the number of voltage pulses can also be increased by a multiple of $N_{max}$ by modifying the properties (duration, amplitude) of the pulses. A memory block according to the invention benefits from a high $R_{off}$ over $R_{on}$ ratio, which can be at least one thousand. Thus, the different levels that can be taken by an OG-CNTFET can be clearly distinguished from each other. However, because of a mismatch variation of about twenty percents between the nanocomponents, for example between their resistance values $R_{on}$, this first exemplary programming circuit is best suited for binary data or for analogue data with a limited number of levels, such as four or height levels. Besides, a complex CMOS control circuit is necessary to determine the number and the duration of voltage pulses to apply for a given input $I_0$-$I_3$. Since a CMOS control circuit is required for each column $C_0$-$C_3$, this greatly limits the density of the overall memory device.

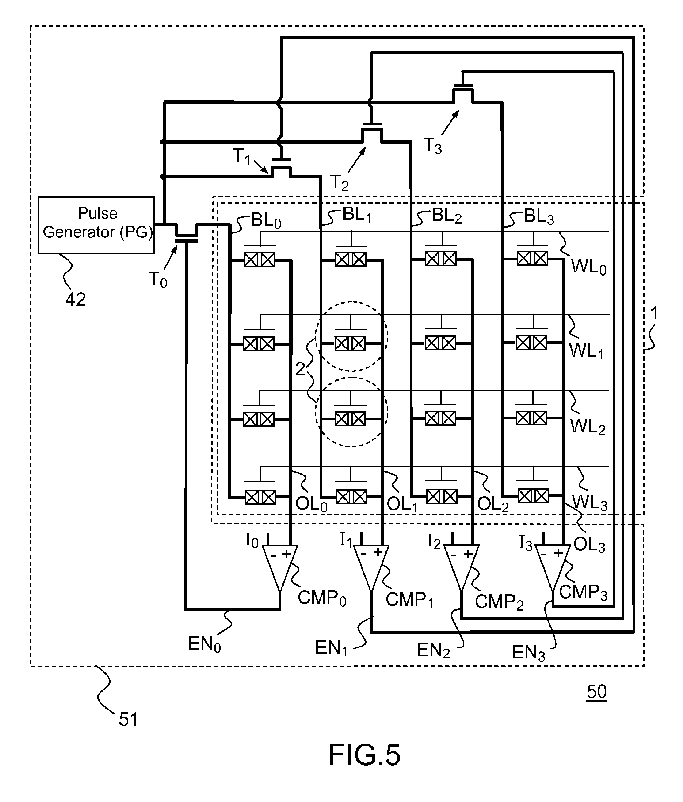

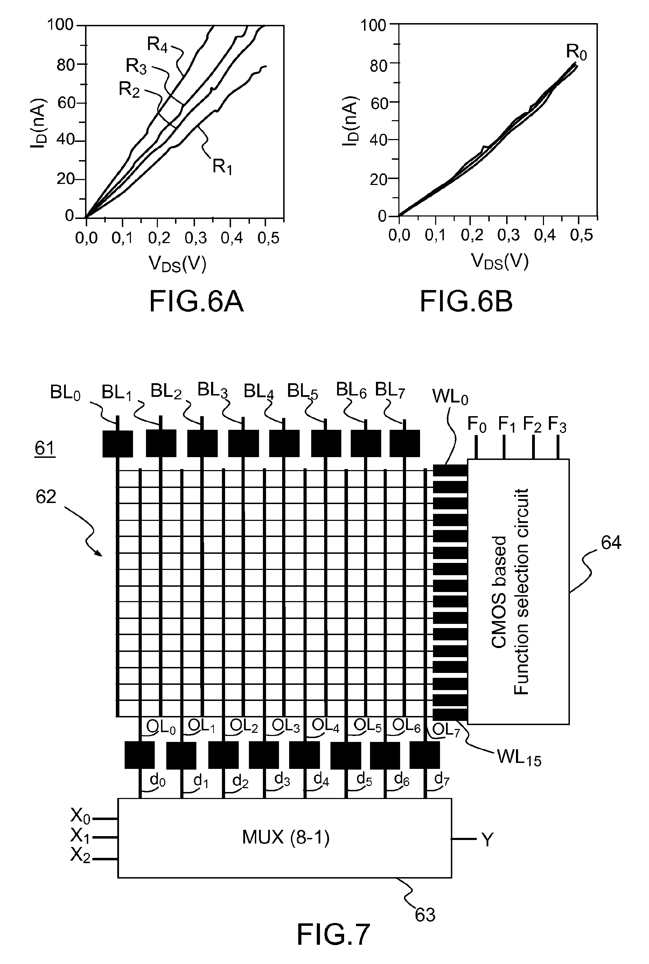

Figure 5 represents a memory device 50 including a memory block 1 according to the invention and a second exemplary circuit 51 for programming it. This circuit 51 comprises a single pulse generator 42 for all columns $C_0$-$C_3$ and, for each column $C_0$-$C_3$, a current comparator $CMP_0$-$CMP_3$ and a transistor $T_0$-$T_3$. As an example, the transistors $T_0$-$T_3$ are MOSFETs. The current comparators $CMP_0$-$CMP_3$ can be carried out in CMOS technologogy. In each column $C_0$-$C_3$, the bit line $BL_0$-$BL_3$ is connected to the source of the respective transistor $T_0$-$T_3$, the output line $OL_0$-$OL_3$ is connected to a first input of the respective current comparator $CMP_0$-$CMP_3$, and the output of each current comparator $CMP_0$-$CMP_3$ is connected to the gate of the respective transistor $T_0$-$T_3$ through enabling lines $EN_0$-$EN_3$. All drains of the transistors $T_0$-$T_3$ are connected to an output of the pulse generator 42. Each current comparator $CMP_0$-$CMP_3$ receives the data to be written $I_0$-$I_3$ on a second input. This second exemplary programming circuit 51 is particularly suitable for the storage of analogue data and allows the mismatch variation of the OG-CNTFETs, for example due to the fabrication process, to be shield by automatic compensation. When a word is to be written in a row $R_0$-$R_3$, the respective word line $WL_0$-$WL_3$ is activated by applying the voltage $V_{G0}$ to it, the other rows $R_0$-$R_3$ being kept in a standby state with the voltage $V_{G1}$. During all the programming period, the potential $V_{Dr}$ is applied to the bit lines $B_{L0}$-$B_{L3}$. The presence of this low potential allows the resistance value $R_{DS}$ of the OG-CNTFETs in the selected row $R_0$-$R_3$ to be sensed. The resulting current $I_{DS}$ on each output line $OL_0$-$OL_3$ is compared with the current that is representative of the data $I_0$-$I_3$. In each column $C_0$-$C_3$, if the current $I_{DS}$ is higher than the respective data current $I_0$-$I_3$, which means that the resistance value $R_{DS}$ is lower than the desired resistance value, a saturation voltage $V_{sat}$ is applied to the enabling line $EN_0$-$EN_3$ so as to saturate the transistor $T_0$-$T_3$ and to allow voltage pulses to reach the bit line $BL_0$-$BL_3$. These voltage pulses gradually increase the resistance value $R_{DS}$ of the OG-CNTFET until the current $I_{DS}$ reaches the data current $I_0$-$I_3$, the resistance $R_{DS}$ being at the desired value. In this case, a sub-threshold voltage is applied to the enabling line $EN_0$-$EN_3$ so as to turn off the transistor $T_0$-$T_3$. Then, the OG-CNTFET of the considered column $C_0$-$C_3$ can no more receive voltage pulses and its resistance $R_{DS}$ is prevented from being modified. The same principle applies for all columns at the same time. When all resistances $R_{DS}$ have been led to the desired value, all transistors $T_0$-$T_3$ are turned off and the following word can be considered for writing. Like for the first exemplary circuit 41, the storage of analogue data requires several voltage pulses for each memory cell 2. However, the second exemplary circuit 51 allows storing more precise values if the number of quantification levels and, consequently, of the maximum number $N_{max}$ of voltage pulses is large enough. $N_{level}$ can be as large as 32 or 64 for example. Experimental measurements shown in figure 6 demonstrate this capacity. The resistances $R_{DS}$ of four different OG-CNTFET memory cells are initially at $R_1$, $R_2$, $R_3$ and $R_4$, as illustrated in figure 6A. After a number of voltage pulses at the drain terminals by comparing with the example desired value $R_0$, the resistances $R_{DS}$ of the four memory cells can be precisely defined to $R_0$, as illustrated in figure 6B. The precision or error margin between the desired value and the effective value $R_{DS}$ of the memory cells can be optimized by reducing the voltage pulse duration and amplitude.

Because of mismatch variations, the resistance value $R_{on}$ is not the same for all the OG-CNTFETs of a memory block. The second exemplary programming circuit 51 can be used in order to initialize the state of the memory cells 2. More particularly, it can be used so as to initialize the resistance values $R_{DS}$ of all the OG-CNTFETs of a memory block to a same resistance value, as shown in figure 6. The mismatch variation can then be ignored for the rest of the programming. Thus, the first exemplary programming circuit 41 can be used to program the memory block 1. The initialisation of the resistance values so as to ignore the mismatch variation can be used for both the digital and analogue storage.

The memory block according to the invention can address a variety of applications dealing either with digital or analogue data. Figure 7 illustrates an exemplary circuit for which the memory block shows a particular interest. This circuit is a multi-function FPGA circuit 61, where FPGA stands for "Field Programmable Gate Array". Such a circuit integrates several functions, one function being able to be carried out at a time depending on chosen parameters. The circuit 61 comprises a memory block 62 according to the invention with sixteen rows $R_0$-$R_{15}$ by height columns $C_0$-$C_7$ of memory cells, a multiplexer 63 and a function selection circuit 64. Each row of the memory block 62 can embody a particular function. Both the multiplexer 63 and the function selection circuit 64 can be implemented in a CMOS control circuit so as to form a hybrid nano/CMOS circuit. The multiplexer 63 comprises height parameter inputs $d_0$-$d_7$, three data inputs $X_0$, $X_1$ and $X_2$, and one output Y, each parameter input $d_0$-$d_7$ being connected to an output line $OL_0$-$OL_7$ of the memory block 62. The function selection circuit 64 comprises four inputs $F_0$-$F_3$ and sixteen outputs, each output being connected to a word line $WL_0$-$WL_{15}$ of the memory block 62. The function selection circuit 64 is dedicated to select one particular function among the available functions according to the signals applied to the inputs $F_0$-$F_3$. To this end, it activates one of the rows $R_0$-$R_{15}$ by applying the voltage $V_{G0}$ to the corresponding word line $WL_0$-$WL_{15}$. The voltage $V_{G1}$ is applied to all other word lines. The reading voltage $V_{Dr}$ is applied to all bit lines $BL_0$-$BL_7$ so that the data stored in the OG-CNTFETs of the selected row can be read on the output lines $OL_0$-$OL_7$. One of these data is selected by the multiplexer 63 according to the signals on the data inputs $X_0$, $X_1$ and $X_2$ and delivered on the output Y. Typically, a FPGA circuit deals with binary data. The memory block 62 is so used as a look-up table with binary data stored in the memory cells. Since the memory of the memory block 62 is non-volatile, the programming of the circuit 61 needs to be performed only once. The function, that is to say the word, which is selected, can be changed at a fixed frequency or according to the needs. The circuit 61 can perform up to sixteen functions without reprogramming the memory block 62. The reconfiguration of the FPGA circuit 61 simply consists in changing the selected word line $WL_0$-$WL_{15}$. Consequently, the reconfiguration speed can be very fast and the power consumption very low. The reconfiguration speed of the FPGA circuit 61 mainly depends on the time required to reconfigure the function selection circuit 64. Only some hundreds of picoseconds are necessary to reconfigure the FPGA circuit 61. The circuit 61 described with reference to figure 7 is able to perform sixteen functions. Obviously, the number of functions can be far greater by using a memory block with a number of word lines at least equal to the desired number of functions. Similarly, the number of data inputs can be increased. The required number of columns in the memory block is increased in consequence so as to be at least equal to $2^{Nx}$, where Nx is the number of data inputs.

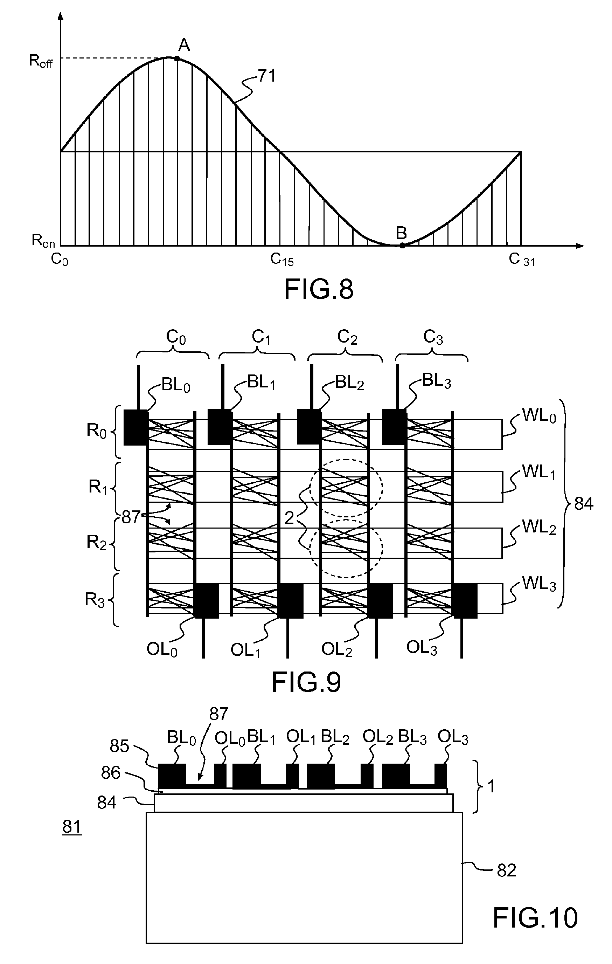

Figure 8 illustrates a type of analogue data that can be advantageously stored by a memory block according to the invention. On this figure is represented a sine curve 71 on one period. This curve 71 can be stored in a single word of a memory block according to the invention. To that end, the curve 71 is sampled in time and each sample is allocated to a column $C_0$-$C_{31}$. On figure 8, it is considered that thirty two samples characterize the curve 71. Obviously, it is possible to use memory blocks with longer words so as to store more samples of a curve. Each sample is stored in an OG-CNTFET of the word by modifying its resistance value $R_{DS}$ so as to be representative of the sample amplitude. The sample with maximum amplitude, noted A on figure 8, corresponds for example to $R_{on}$ and the sample with minimum amplitude, noted B on figure 8, corresponds for example to $R_{off}$. The storage of these analogue data can be performed by using a programming circuit like the one presented with reference to figure 5.

In comparison with conventional storage solutions, the memory block according to the invention does not need an analogue-to-digital converter for the programming and a digital-to-analogue converter for the reading. Moreover, thanks to the analogue storage, the number of memory cells is reduced to one memory cell per sample.

Figures 9 and 10 illustrate a possible implementation of a memory device comprising a memory block according to the invention and a CMOS control circuit. They are respectively a schematic top view and a schematic cross-section view of this hybrid nano/CMOS memory device. The hybrid nano/CMOS memory device 81 comprises a CMOS control circuit 82 forming a first block and a memory block 1 of four rows $R_0$-$R_4$ by four columns $C_0$-$C_4$ of CNTFETs forming a nano building block implemented on top of the CMOS control circuit 82. The CMOS control circuit 82 advantageously comprises a programming circuit such as the one described with reference to figure 4 or to figure 5. It can also comprise the MOS transistors required for the global control of the memory block 1. More generally, the CMOS control circuit 82 can comprise all CMOS circuits that are to be used in conjunction with the memory block 1. The latter comprises a first metal layer 84, a second metal layer 85 and an oxide barrier 86 between these two metal layers 84 and 85. The first metal layer 84 is designed so as to form the word lines $WL_0$-$WL_3$, that is to say the gates G of the CNTFETs and the second metal layer 85 is designed so as to form both the bit lines $BL_0$-$BL_3$ and the output lines $OL_0$-$OL_3$, that is to say the drains D and the sources S of the CNTFETs. At each intersection of a row $R_0$-$R_3$ and a column $C_0$-$C_3$, a nanotube network 87 is implemented on a word line $WL_0$-$WL_3$ between a bit line $BL_0$-$BL_3$ and an output line $OL_0$-$OL_3$ of a same column $C_0$-$C_3$. Possibly, the nanotube network 87 can be replaced by a single nanotube, a nanowire network, a single nanowire, a nanoribbon network or a single nanoribbon. The memory block 1 so forms a planar cross-bar architecture with only two metal layers above the CMOS control circuit 82. In order to design a memory block 1 with OG-CNTFETs, a polymer material layer (not represented) can cover the memory block 1 or at least the OG-CNTFETs. It so forms a common optical gate $G_2$ for all OG-CNTFETs of the memory block 1.

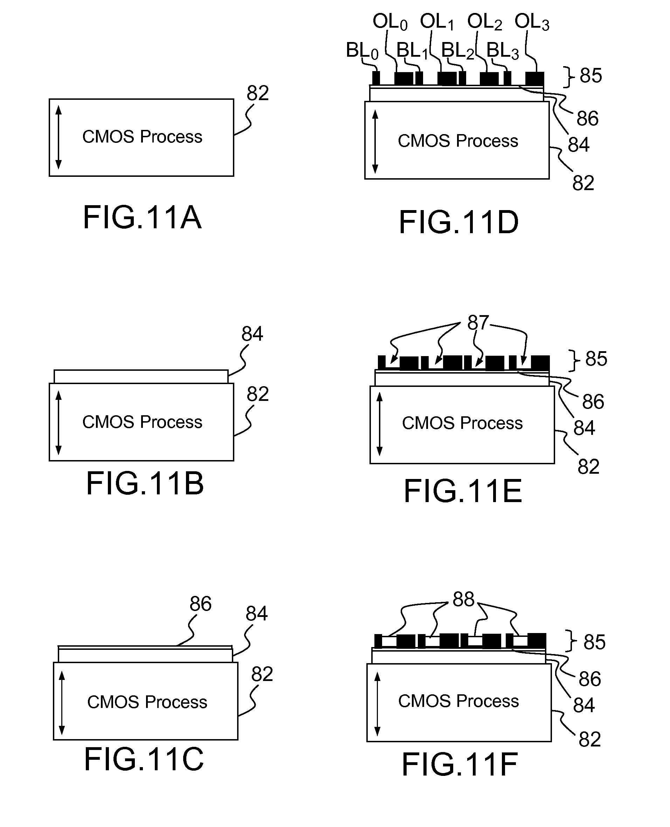

Figures 11A-11F illustrate an example of fabrication process for the hybrid nano/CMOS memory device 81 represented on figures 9 and 10. In a first step, represented by figure 11A, the CMOS control circuit 82 is manufactured. The CMOS control circuit 82 can be a multilayer printed circuit. In a second step, represented by figure 11B, the first metal layer 84 is added on top of the CMOS control circuit 82 via a first mask in order to form the word lines $WL_0$-$WL_3$. In a third step, represented by figure 11C, the oxide barrier 86 is deposited. In a fourth step, represented by figure 11D, the second metal layer 85 is deposited via a second mask so as to form the bit lines $BL_0$-$BL_3$ and the output lines $OL_0$-$OL_3$. In a fifth step, represented by figure 11E, the nanotube networks 87 are grown or deposited between the drains D and the sources S of the OG-CNTFETs through a third mask. Finally, in a sixth step, represented by figure 11F, P3OT material 88 is deposited at least on the nanotube networks 87. The second and third steps can be easily included in the manufacture process of the CMOS control circuit 82. In this case, only one additional metal layer (the second metal layer 85) and two additional masks (the second and the third masks) are required after the manufacture process of the CMOS control circuit 82. It lowers the fabrication cost and improves the reliability of the hybrid nano/CMOS memory device 81.

**Claims**

1. Memory device comprising an array of non-volatile memory cells (2), **characterised in that**

   - each memory cell (2) is embodied by a nanoscale component having at least three terminals,
   - an electrical characteristic ($R_{DS}$) between a first and a second terminal (D, S) of each nanoscale component (2) being able to represent a data and being able to be modified by applying a signal to said first terminal (D) or to said second terminal (S),
   - a third terminal (G) of each nanoscale component (2) being able to prevent the electrical characteristic ($R_{DS}$) of the corresponding nanoscale component from being modified and sensed by applying a positive and non-null voltage ($V_{G1}$) to it.

2. Memory device according to claim 1, **characterised in that**

   - the nanoscale components (2) are field-effect transistors,
   - each field-effect transistor comprising a drain (D) and a source (S) forming the first and second terminals of the corresponding nanoscale component,
   - a resistance ($R_{DS}$) between the drain (D) and the source (S) of each field-effect transistor being able to be modified by voltage pulses applied to its drain (D) or to its source (S),
   - each field-effect transistor further comprising a gate (G) forming the third terminal of the corresponding nanoscale component and preventing the resistance ($R_{DS}$) between the drain (D) and the source (S) of the corresponding field-effect transistor from being modified and sensed when a positive and non-null gate voltage ($V_{G1}$) is applied to it.

3. Memory device according to claim 2, **characterised in that** the field-effect transistors each comprise a second gate ($G_2$), their resistances ($R_{DS}$) between the drains (D) and the sources (S) returning to an initial state ($R_{on}$) by applying a negative and non-null voltage to their second gate ($G_2$).

4. Memory device according to claim 2, **characterised in that** the field-effect transistors (2) are carbon nanotube field-effect transistors.

5. Memory device according to claim 4, **characterised in that** the carbon nanotube field-effect transistors each comprise an optical gate ($G_2$), their resistances ($R_{DS}$) between the drains (D) and the sources (S) returning to an initial state ($R_{on}$) by exposing their optical gate ($G_2$) to a light beam of a given wavelength.

6. Memory device according to claim 5, **characterised in that** the optical gates ($G_2$) of all carbon nanotube field-effect transistors are shared.

7. Memory device according to any one of the preceding claims, **characterised in that**

   - the array of memory cells comprises M rows ($R_0$-$R_3$) by N columns ($C_0$-$C_3$) of memory cells (2) enabling the storage of M words of N bits each,
   - the first terminals (D) of the nanoscale components in each column ($C_0$-$C_3$) being respectively connected together so as to form bit lines ($BL_0$-$BL_3$),
   - the second terminals (S) of the nanoscale components in each column ($C_0$-$C_3$) being respectively connected together so as to form output lines ($OL_0$-$OL_3$), and
   - the third terminals (G) of the nanoscale components in each row ($R_0$-$R_3$) being respectively connected together so as to form word lines ($WL_0$-$WL_3$).

8. Memory device according to any one of the preceding claims, **characterised in that** it further comprises a CMOS control circuit (82) comprising a first metal layer (84) and an oxide barrier (86) forming part of the array of memory cells.

9. Memory device according to claims 7 and 8, **characterised in that** the array of memory cells comprises a second metal layer (85), the first metal layer (84) embodying the word lines ($WL_0$-$WL_3$) and the second metal layer (85) embodying the bit lines ($BL_0$-$BL_3$) and the output lines ($OL_0$-$OL_3$).

10. Memory device according to claims 2 and 9, **characterised in that** the field-effect transistors each comprise at least a nanotube, at least a nanowire or at least a nanoribbon (87) implemented on a word line ($WL_0$-$WL_3$) between a bit line ($BL_0$-$BL_3$) and an output line ($OL_0$-$OL_3$) of a given column ($C_0$-$C_3$).

11. Memory device according to claims 7 and 8, **characterised in that** the CMOS control circuit (82) comprises a programming circuit (41, 51) allowing to write data word by word in the array of memory cells (2), the word lines ($WL_0$-$WL_3$) being successively selected.

12. Memory device according to claim 11, **character-**

**ised in that** the programming circuit (41) comprises a pulse generator (42) for each column ($C_0$-$C_3$) of the array of memory cells (2), the pulse generators (42) being able to deliver voltage pulses of given amplitude and duration, an output of each pulse generator (42) being connected to a bit line ($BL_0$-$BL_3$).

**13.** Memory device according to claim 11, **characterised in that** the programming circuit (51) comprises a pulse generator (42) and, for each column ($C_0$-$C_3$) of the array of memory cells (2), a current comparator ($CMP_0$-$CMP_3$) and a commandable switch ($T_0$-$T_3$), each current comparator ($CMP_0$-$CMP_3$) allowing to compare the data ($I_0$-$I_3$) to be stored in a nanoscale component of the corresponding column ($C_0$-$C_3$) with the data ($I_{DS}$) currently stored in said nanoscale component, each commandable switch ($T_0$-$T_3$) connecting the pulse generator (42) to one bit line ($BL_0$-$BL_3$) and being controlled by an output of the corresponding current comparator ($CMP_0$-$CMP_3$).

**14.** Memory device according to claims 7 and 8, **characterised in that** the CMOS control circuit (82) comprises a field programmable gate array able to carry out one function at a time among M functions, each function being embodied by a word, the field programmable gate array comprising a function selection circuit (64) connected to the word lines ($WL_0$-$WL_{15}$) and being able to select a word for reading, and a multiplexer (63) connected to the output lines ($OL_0$-$OL_7$) and delivering an output (Y) according to data inputs ($X_0$, $X_1$, $X_2$) and to the selected word.

**15.** Memory chip **characterised in that** it comprises an array of memory devices (1, 81) according to any preceding claim.

**16.** Storage of a discrete signal over a period of time, **characterised in that** the discrete signal (71) is stored in a word of a memory device (1) according to claim 4 and possibly to any one of claims 5 to 11, the electrical characteristic ($R_{DS}$) between the first and second terminals (D, S) of each nanoscale component associated to said word being representative of an analogue value of a sample.

FIG.1

FIG.2

FIG.3

EP 2 309 515 A1

FIG.4

FIG.5

FIG.6A

FIG.6B

FIG.7

FIG.8

FIG.9

FIG.10

FIG.11A

FIG.11D

FIG.11B

FIG.11E

FIG.11C

FIG.11F

# EP 2 309 515 A1

**EUROPEAN SEARCH REPORT**

Application Number

EP 09 17 2679

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | V. Derycke et al.: "Dynamic Performances of Carbon nanotube Transistors and Programmable Devices for Adaptive Architectures"[Online] 11 September 2009 (2009-09-11), pages 1/25-25/25, XP002573396 Presentation TNT conference Trends in Nanotechnology, Barcelona (Spain) September 07-11, 2009 Retrieved from the Internet: URL:http://tntconf.org/2009/Presentaciones/TNT2009_Derycke.pdf> [retrieved on 2010-03-15] * page 14/25 - page 24/25 * | 1,2,4,5, 7,15 | INV. G11C11/54 G11C11/56 G11C27/00 G11C13/02 |
| Y | | 3,6 | |
| X | US 2006/250856 A1 (BERTIN CLAUDE L [US] ET AL BERTIN CLAUDE L [US] ET AL) 9 November 2006 (2006-11-09) * paragraph [0064] - paragraph [0077]; figures 2,3 * | 1 | |
| Y | BORGHETTI J ET AL: "Optoelectronic Switch and Memory Devices Based on Polymer-Functionalized Carbon Nanotube Transistors" ANGEWANDTE CHEMIE. INTERNATIONAL EDITION, WILEY VCH VERLAG, WEINHEIM, no. 18, 1 January 2006 (2006-01-01), pages 2535-2540, XP002464501 ISSN: 1433-7851 * page 2537, left-hand column, last paragraph - right-hand column, paragraph 2; figure 3 * * page 2540, left-hand column, lines 6-11 * | 3,6 | TECHNICAL FIELDS SEARCHED (IPC) G11C |

-/--

~~The present search report has been drawn up for all claims~~

| Place of search | Date of completion of the search | Examiner |
|---|---|---|
| The Hague | 19 March 2010 | Colling, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 09 17 2679

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | G. Agnus et al: "Carbon nanotube Programmable Devices For Adaptive Architectures"[Online] 11 September 2009 (2009-09-11), pages 1/2-2/2, XP002573474 Poster TNT conference Trends in Nanotechnology, Barcelona (Spain) September 07-11, 2009 Retrieved from the Internet: URL:http://www.tntconf.org/2009/Abstracts/Posters/TNT2009_Agnus.pdf?TNT=5ba318f4fccb64e7628a9cb7f38cb3be> [retrieved on 2010-03-15] * page 1, paragraph 3 - page 2, last paragraph; figures 1,2 * ----- | 1-7,15 | |
| | | | TECHNICAL FIELDS SEARCHED (IPC) |

~~The present search report has been drawn up for all claims~~

| Place of search | Date of completion of the search | Examiner |
|---|---|---|
| The Hague | 19 March 2010 | Colling, Pierre |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

Europäisches
Patentamt

European
Patent Office

Office européen
des brevets

**Application Number**

EP 09 17 2679

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

[X] None of the further search fees have been paid within the fixed time limit. The present European search report has been drawn up for those parts of the European patent application which relate to the invention first mentioned in the claims, namely claims:

1-7, 15

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 09 17 2679

The Search Division considers that the present European patent application does not comply with the
requirements of unity of invention and relates to several inventions or groups of inventions, namely:

```
1. claims: 1-7, 15

                    Invention 1
                        ---

2. claims: 8-14

                    Invention 2
                        ---

3. claim: 16

                    Invention 3
                        ---
```

**ANNEX TO THE EUROPEAN SEARCH REPORT
ON EUROPEAN PATENT APPLICATION NO.**

EP 09 17 2679

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2010

| Patent document cited in search report | Publication date | Patent family member(s) | | Publication date |
|---|---|---|---|---|
| US 2006250856 A1 | 09-11-2006 | CA | 2608106 A1 | 16-11-2006 |
| | | EP | 1889260 A2 | 20-02-2008 |
| | | JP | 2008541458 T | 20-11-2008 |
| | | US | 2009154218 A1 | 18-06-2009 |
| | | WO | 2006122111 A2 | 16-11-2006 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7323730 B